# DEMANDE DE BREVET EUROPEEN

(11) **EP 4 557 350 A2**
(43) Date de publication de la demande: **21.05.2025**
(21) Numéro de dépôt: 25166586.5
(22) Date de dépôt: 05.07.2018
(51) Int. Cl.: H01L 21/322

(54) **SUBSTRAT POUR UN DISPOSITIF INTÉGRÉ RADIOFRÉQUENCE ET SON PROCÉDÉ DE FABRICATION**

(62) Demande divisionnaire de: 18762567.8
(71) Demandeur: SOITEC, 38190 Bernin (FR)
(72) Inventeur: VEYTIZOU, Christelle, 38190 BERNIN (FR); REYNAUD, Patrick, 38190 BERNIN (FR); KONONCHUCK, Oleg, 38190 BERNIN (FR); ALLIBERT, Frédéric, 38190 BERNIN (FR)
(74) Mandataire: IP Trust

(57) **Abrégé**

L'invention porte sur un substrat (1) pour des applications dans les domaines de l'électronique et de la microélectronique radiofréquence comprenant un substrat de base (3) ; une unique couche de carbone (2) disposée sur et directement en contact avec le substrat de base (3), la couche de carbone (2) présentant une épaisseur strictement comprise entre 1nm et 5nm ; une couche d'isolant électrique (4) disposée sur la couche de carbone (2); une couche de dispositifs (5) disposée sur la couche d'isolant (4). L'invention porte également sur un procédé de fabrication de ce substrat.

## Description

### DOMAINE DE L'INVENTION

La présente invention concerne un substrat pour un dispositif intégré radiofréquence. Elle concerne également le procédé de fabrication d'un tel substrat.

### ARRIERE PLAN TECHNOLOGIQUE DE L'INVENTION

Les dispositifs intégrés sont usuellement formés sur des substrats qui servent principalement de support à leur fabrication. Toutefois, l'accroissement du degré d'intégration et des performances attendues de ces dispositifs entraine un couplage de plus en plus important entre leurs performances et les caractéristiques du substrat sur lequel ils sont formés. C'est particulièrement le cas des dispositifs RF, traitant des signaux dont la fréquence est comprise entre environ 3kHz et 300GHz, qui trouvent notamment leur application dans le domaine des télécommunications (téléphonie, Wi-Fi, Bluetooth...).

A titre d'exemple de couplage dispositif/substrat, les champs électromagnétiques, issus des signaux hautes fréquences se propageant dans les dispositifs intégrés, pénètrent dans la profondeur du substrat et interagissent avec les éventuels porteurs de charge qui s'y trouvent. Il s'en suit une consommation inutile d'une partie de l'énergie du signal par perte de couplage et des influences possibles entre composants par diaphonie (« crosstalk » selon la terminologie anglo-saxonne).

Selon un second exemple de couplage, les porteurs de charges du substrat peuvent entrainer la génération d'harmoniques non voulues, pouvant interférer avec les signaux se propageant dans les dispositifs intégrés et dégradant leurs qualités.

Ces phénomènes sont notamment observables lorsque le substrat employé, du type « silicium sur isolant », comprend une couche enterrée d'isolant, entre un support et une couche de dispositifs sur et dans laquelle sont formés les dispositifs intégrés. Les charges piégées dans l'isolant conduisent à accumuler sous cette couche d'isolant, dans le support, des charges de signes complémentaires formant un plan conducteur. Dans ce plan conducteur, les charges mobiles sont susceptibles d'interagir fortement avec les champs électromagnétiques générés par les composants de la couche utile. On observe donc une forte chute de la résistivité du support, dans un plan situé directement sous la couche enterrée d'isolant, même lorsque ce support présente une caractéristique électrique hautement résistive.

Pour se prémunir ou limiter ce phénomène, il est connu d'insérer entre l'isolant enterré et le support, directement sous l'isolant, une couche de piégeage de charges, par exemple une couche de 1 à 5 microns de silicium polycristallin. Les joints des grains formant le poly cristal constituent alors des pièges pour les porteurs de charges, ceux-ci pouvant provenir de la couche de piégeage elle-même ou du support sous-jacent. De la sorte, on prévient l'apparition du plan conducteur sous l'isolant et la chute de résistivité du support. La fabrication de ce type de substrat est par exemple décrite dans les documents FR2860341, FR2933233, FR2953640, US2015115480, US7268060 ou US6544656.

Le document US20150115480 propose de former la couche de piégeage sous la forme d'un empilement de couches élémentaires polycristalline ou amorphe en SiGe, Ge ou SiC, chaque couche élémentaire pouvant présenter une épaisseur d'au moins environ 5nm et étant recouverte d'une couche de passivation de quelques Angstrom.

Le document US2016071959 décrit une structure de type silicium sur isolant comprenant sur un support résistif une éventuelle fine couche d'isolant de quelques nanomètres d'épaisseur et une couche amorphe de silicium dopé au carbone présentant une épaisseur comprise entre 25nm et 7 microns. La concentration en carbone est comprise entre 1 et 10%.

Le document US20130168835 décrit un procédé de formation d'un substrat de silicium sur isolant comprenant la fourniture d'un substrat support; la formation d'une couche de matériau à haute résistivité sur le substrat support, la couche de matériau à haute résistivité présentant une épaisseur comprise entre 10 et 50 microns et comprenant l'un parmi du carbure de silicium amorphe ou polycristallin, du diamant amorphe ou polycristallin; la formation d'une couche isolante sur la couche de matériau à haute résistivité; et l'assemblage d'une plaquette donneuse à une surface supérieure de la couche isolante pour former le substrat de SOI.

La solution consistant à fournir une couche de piégeage à base de matériau semi-conducteur polycristallin ou amorphe, bien que tout à fait efficace, est relativement onéreuse, notamment lorsque la couche de piégeage est épaisse ou composée d'un empilement de couches élémentaires. De plus la formation d'une couche épaisse, par exemple de plusieurs microns, peut conduire à déformer la plaquette sur laquelle cette couche est formée ou à rendre particulièrement rugueuse cette couche, ce qui rend particulièrement délicat le procédé de fabrication.

La présente invention vise à fournir un substrat pour des applications dans les domaines de l'électronique et de la microélectronique radiofréquence qui soit simple et peu coûteux à fabriquer tout en présentant un niveau de performances amélioré vis-à-vis d'un substrat du type silicium sur isolant ne comportant pas de couche de piégeage.

### BREVE DESCRIPTION DE L'INVENTION

En vue de la réalisation de ce but, l'objet de l'invention propose un substrat selon la revendication 1.

La couche de carbone de très faible épaisseur forme une couche de piégeage très simple à fabriquer et, de manière surprenante, particulièrement efficace.

Selon d'autres caractéristiques avantageuses et non limitatives de l'invention, prises seules ou selon toute combinaison techniquement réalisable :
- le substrat de base est un substrat de silicium monocristallin présentant une résistivité inférieure à 100 ohm.cm ;
- lequel substrat de base est un substrat de silicium monocristallin présentant une résistivité supérieure à 100 ohm.cm ;
- la couche de carbone présente une épaisseur comprise entre 1 et 3nm ;
- le substrat comprend en outre une couche de collage disposée entre, et en contact avec, la couche de carbone et la couche d'isolant électrique ;
- la couche de collage présente une épaisseur inférieure à 10nm ;
- la couche de collage est en silicium amorphe, polycristallin ou en dioxyde de silicium ;
- la couche d'isolant est en dioxyde de silicium ;
- la couche de dispositifs comprend du silicium ;
- la couche de dispositifs comprend au moins un dispositif radiofréquence.

### BREVE DESCRIPTION DES DESSINS

D'autres caractéristiques et avantages de l'invention ressortiront de la description détaillée de l'invention qui va suivre en référence aux figures annexées sur lesquelles :
- La figure 1 représente un substrat conforme à un premier mode de réalisation de l'invention ;
- la figure 2 représente un substrat conforme à un second mode de réalisation de l'invention ;
- la figure 3 représente un procédé de fabrication d'un substrat conforme à l'invention.

### DESCRIPTION DETAILLEE DE L'INVENTION

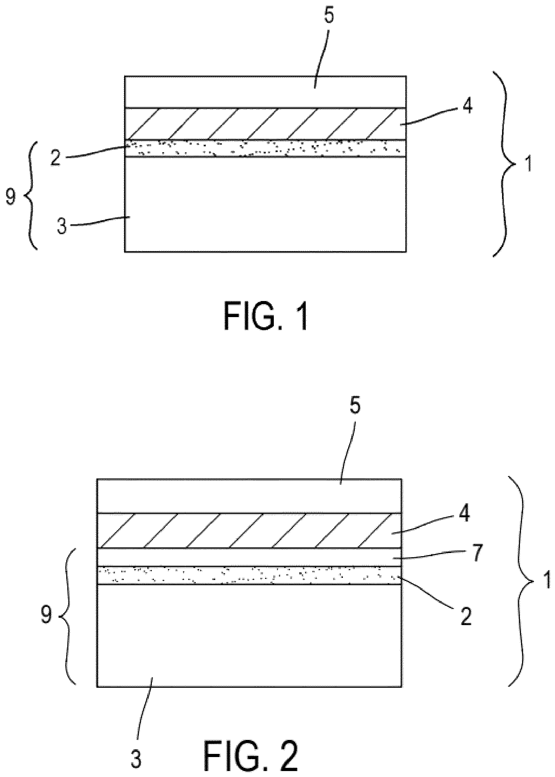

La figure 1 représente schématiquement un premier mode de réalisation d'un substrat 1 pour des applications dans les domaines de l'électronique et de la microélectronique radiofréquence conforme à l'invention.

Le substrat 1 de ce premier mode de réalisation comprend un substrat de base 3, une couche de carbone 2 disposée sur et directement en contact avec le substrat de base 3, la couche de carbone présentant une épaisseur strictement comprise entre 1nm et 5nm, et préférentiellement entre 1 et 3nm ; une couche d'isolant électrique 4 disposée sur la couche de carbone 2 et une couche de dispositifs 5 disposée sur la couche d'isolant 4. Le substrat de base 3 muni de la couche de carbone 2 forme le support 9 du substrat 1.

Le substrat 1 peut prendre la forme d'une plaquette, circulaire, de dimension normalisée, par exemple de 200 mm ou 300 mm, voire 450mm de diamètre. C'est notamment le cas lorsque le substrat, et notamment la couche de dispositifs 5, est encore vierge de tout dispositif. Mais l'invention n'est nullement limitée à ces dimensions ou à cette forme.

Ainsi, lorsque le substrat 1 forme le support d'un dispositif radiofréquence fini ou semi-fini, il prendra la forme d'un bloc de matériau de section longitudinale rectangulaire ou carré dont les dimensions, de quelques millimètres à quelques centimètres, correspondent aux dimensions du dispositif intégré.

Le substrat de base 3 présente une épaisseur de plusieurs centaines de microns. Préférentiellement, le substrat de base 3 présente une résistivité élevée, supérieure à 100 ou 1000 ohms.cm, et plus préférentiellement encore supérieure à 3000 ohms.cm. On limite de la sorte la densité des charges, trous ou électrons, qui sont susceptibles de se déplacer dans le substrat de base 3, et donc détériorer la performance RF du substrat. Mais l'invention n'est pas limitée à un substrat de base présentant une telle résistivité, et elle procure également des avantages de performance RF lorsque le substrat de base présente une résistivité plus conforme, de l'ordre de quelques centaines d'ohms.cm, ou 100 ohms.cm ou moins.

Pour des raisons de disponibilité et de coût, le substrat de base 3 est préférentiellement en silicium, et notamment en silicium monocristallin. Il peut s'agir par exemple d'un substrat CZ à faible teneur en oxygène interstitiel qui présente, comme cela est bien connu en soi, une résistivité qui peut être supérieure à 1000 ohms.cm. Le substrat de base peut alternativement être formé d'un autre matériau : il peut s'agir par exemple de saphir, de carbure de silicium, de silicium-germanium, matériaux III-V,... Il peut s'agir alternativement encore d'un substrat CZ monocristallin plus standard, dont la résistivité est inférieure à 100 ohms.cm.

Le substrat 1 comporte également, sur et directement en contact avec le substrat de base 3, une unique couche de carbone 2 présentant une épaisseur strictement comprise entre 1nm et 5 nm, et préférentiellement entre 1 et 3nm. La couche de carbone 2 a pour fonction de limiter la perte de résistivité qui est généralement observée dans le support d'un substrat de type « silicium sur isolant », sous la couche d'isolant électrique, comme cela a été rappelé en introduction.

Dans le cadre de la présente invention, on désigne par « couche de carbone » une couche constituée à partir d'atomes de carbone uniquement. La migration ou la diffusion de ces atomes dans l'épaisseur du substrat de base 3, ou la diffusion des atomes constituant le substrat de base 3 dans la couche de carbone 2, sur quelques plans atomiques, peut conduire à la formation d'une couche, riche en carbone mais pouvant également comprendre d'autres espèces, notamment celles constituant le substrat de base.

De manière surprenante, il a été observé que cette couche de carbone 2, même de très faible épaisseur, était très efficace pour améliorer les performances RF du substrat 1, notamment pour limiter, voire parer entièrement à la chute de résistivité du support 9 à son interface avec la couche isolante 4. A titre d'exemple, une couche de carbone 2 de 3nm déposée sur un substrat de base 3 présentant une résistivité supérieure à 1000 ohms.cm permet d'obtenir un gain en performance de 20 dbm lors d'une mesure du paramètre de distorsion de seconde harmonique à partir de lignes coplanaires, en comparaison avec un substrat de base ne disposant pas de la couche de carbone 2. Cette mesure de caractérisation est notamment décrite dans le document intitulé « White paper - RF SOI Characterisation » de mars 2016, publié par la société SOITEC.

Cela est dû au fait qu'une telle couche comporte une densité importante de défauts formant des pièges aux porteurs de charges. Cette densité de défauts est de plusieurs ordres de grandeur supérieure à ce qui pourrait être obtenu avec une couche cristalline ou amorphe d'un matériau semi-conducteur de même épaisseur, en silicium, en silicium-germanium, en carbure de silicium ou en tout autre matériau.

Du fait de son extrême finesse de quelques nanomètres, la couche de carbone 2 est également peu complexe à réaliser et peu onéreuse, en comparaison avec les couches de piégeage de plusieurs microns d'épaisseur de l'état de la technique, en matériau polycristallin et amorphe.

Comme cela est représenté sur la figure 1, le substrat 1 comprend une couche d'isolant électrique 4 directement sur la couche de carbone 2. Le substrat comprend également une couche de dispositifs 5, sur et en contact avec la couche d'isolant 4. Les caractéristiques de ces deux couches ne sont pas essentielles à l'invention. A titre d'exemple, la couche d'isolant 4 peut être constituée ou comprendre du dioxyde de silicium ou du nitrure de silicium. Il peut également s'agir d'un empilement de ces matériaux. L'épaisseur de la couche d'isolant 4 peut être comprise entre 10nm et 10 microns.

La couche de dispositifs 5 est usuellement en silicium monocristallin, mais il pourrait s'agir de tout autre matériau, semi-conducteur ou non, selon la nature du dispositif RF destiné à y être formé. Ainsi, pour former un dispositif à onde acoustique, la couche de dispositifs 5 peut être constituée d'un matériau isolant tel que du tantalate de lithium ou du niobate de lithium. L'épaisseur de la couche de dispositifs peut être comprise entre 10nm et 10 microns. Les dispositifs peuvent être formés dans cette couche de dispositifs 5 lorsque celle-ci repose sur le support 9, mais comme cela sera exposé par la suite, les dispositifs peuvent également avoir été formés dans cette couche avant que celle-ci ait été reportée sur le support 9. Naturellement, la couche de dispositifs est continue, c'est à dire qu'elle recouvre la majeure partie de la face principale du substrat 1, de manière à ce que ce substrat puisse accueillir une densité importante de composants.

La figure 2 représente schématiquement un second mode de réalisation d'un substrat 1 conforme à l'invention.

Le substrat 1 de ce second mode comprend le même substrat de base 3, la même couche de carbone 2, la même couche d'isolant électrique 4 et la même couche de dispositifs 5 que dans le substrat 1 du premier mode de réalisation. Par souci de concision, leurs descriptions ne seront donc pas répétées, et les mêmes commentaires qui ont été portés en relation avec la description du substrat 1 du premier mode de réalisation s'appliquent également au substrat 1 du second mode.

Comme cela est bien visible sur la figure 2, le substrat 1 comprend également une couche de collage 7 disposée entre, et en contact avec, la couche de carbone 2 et la couche d'isolant électrique 4.

Cette couche de collage 7 a pour fonction de faciliter la fabrication du substrat comme cela sera exposé dans le détail dans la suite de cet exposé. Elle peut être constituée de silicium amorphe, polycristallin ou de dioxyde de silicium, mais d'autres matériaux sont également envisageables. Son éventuelle influence sur le niveau de performance RF du substrat est secondaire. On veillera toutefois à ce qu'elle ne détériore pas ces performances. A cet effet, on limitera au maximum son épaisseur et sa conductivité. De préférence, la couche de collage 7 présente une épaisseur inférieure à 10nm. Lorsqu'elle est formée d'un matériau semi-conducteur, la couche de collage 7 présente une concentration en dopant inférieure à 10 E14 atomes par centimètre cube. Elle peut être riche en carbone afin de la rendre résistive.

Quel que soit le mode de réalisation choisi, le substrat 1 ne contient aucune autre couche que l'unique couche de carbone 2 et, le cas échéant, la couche de collage 7, entre le substrat de base 3 et la couche d'isolant électrique 4. Le niveau de performance RF, et notamment la résistivité du support 9 dans un plan situé sous la couche isolante 4, est essentiellement assuré par la couche de carbone 2.

Un avantage du substrat 1 de l'invention est que la couche de carbone 2 n'est pas sensible au traitement thermique que ce substrat pourrait subir. Elle n'est pas susceptible de perdre ses effets de piégeage de charge par recristallisation comme c'est le cas des couches de piégeage polycristallines ou amorphes de l'état de la technique. On peut donc exposer le substrat 1, au cours de sa fabrication ou au cours de la formation des dispositifs RF dans et sur la couche de dispositifs 5, à une température importante, par exemple jusqu'à 1200°C dans le cas où le substrat de base 3 et le couche de dispositifs 5 sont en silicium.

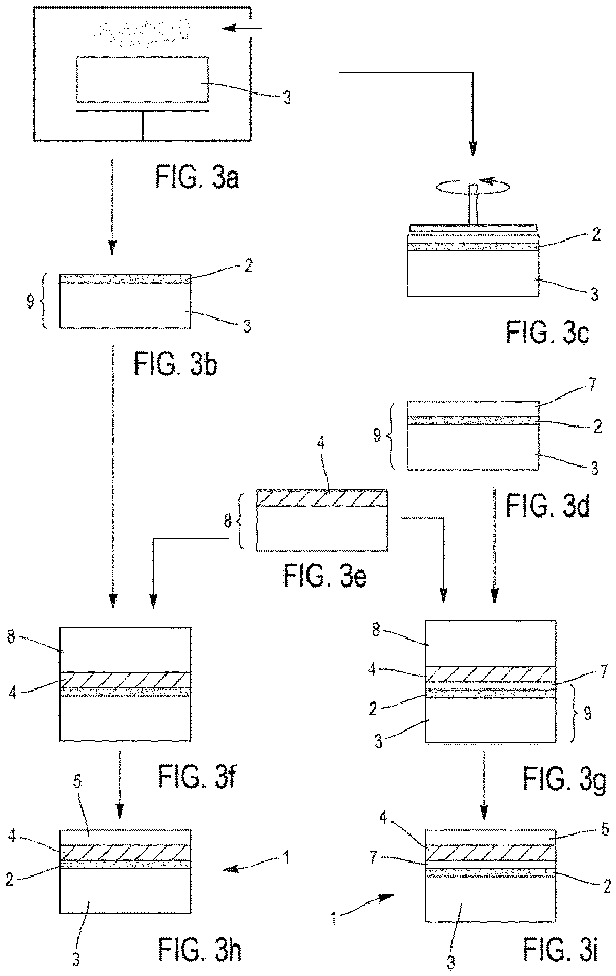

En référence à la figure 3, on expose un exemple d'un procédé de fabrication conforme à l'invention.

La fabrication du substrat 1 comprend, d'une manière générale, la préparation du substrat de base 3 pour le munir de la couche de carbone 2 (et le cas échéant de la couche de collage 7) pour former le support 9, et le transfert d'une couche de dispositifs 5 sur le support 9.

La préparation du substrat de base 3 est particulièrement simple et réalisable avec des équipements standards de l'industrie. On fournit le substrat de base 3 que l'on place dans une chambre de dépôt conventionnel ou même dans une chambre d'un four de recuit dans laquelle on peut faire circuler un gaz de manière à contrôler son atmosphère. Comme cela est bien connu en soi, le substrat de base 3 peut être préparé avant d'être exposé à un gaz précurseur contenant du carbone, par exemple pour éliminer une couche d'oxyde natif de sa surface.

Ainsi que cela est représenté schématiquement sur la figure 3a, la chambre est ensuite emplie d'un gaz précurseur contenant du carbone, par exemple du C3H8, à une température de l'ordre de 1000°C, et préférentiellement supérieure à 1000°C, pour exposer le substrat de base 3 à ce gaz précurseur et former la couche de carbone 2. Le gaz précurseur peut comprendre ou être composé, à titre d'exemple, de méthane (CH4), d'éthane (C2H6), de propane (C3H8), acétylène (C2H2), d'éthylène (C2H4), ... Les espèces carbonées libérées par le gaz précurseur sous l'effet de la température se lient aux espèces atomiques formant la surface exposée du substrat de base 3. Cette réaction peut s'interrompre naturellement lorsque cette surface est saturée en carbone, conduisant à la formation d'une couche de carbone 2 présentant une épaisseur de quelques plans atomiques, strictement comprise entre 1 et 5nm et voire même comprise entre 1 et 3nm. La durée de cette exposition est suffisante pour que la couche de carbone recouvre la surface exposée du substrat de base 3 et présenter l'épaisseur strictement comprise entre 1 et 5nm, ou entre 1 et 3nm. La durée d'exposition est de l'ordre de quelques minutes, idéalement et de manière non limitative entre 2 et 10 minutes, et, au terme de cette durée, la chambre peut être purgée du gaz précurseur contenant du carbone ou son flux interrompu. Comme on l'a évoqué antérieurement, il est possible que des atomes de carbone diffusent sur quelques plans atomiques dans l'épaisseur du substrat de base 2. Similairement, des espèces atomiques du substrat de base peuvent également migrer dans la couche de carbone déposée. En tout état de cause, et quelle que soit la nature exacte de la couche qui se forme, seuls des atomes de carbone sont déposés pour constituer la couche de carbone 2.

A l'issue de cette étape, on dispose donc du support 9, représenté sur la figure 3b. Ce support est destiné à être assemblé, par exemple par adhésion moléculaire à un substrat source **8.** A ce titre, on note que la surface exposée de la couche de carbone 2 ne nécessite pas de traitement de lissage particulier, notamment par polissage, elle présente en effet directement après sa formation une rugosité, inférieure à 5A RMS, suffisamment faible pour permettre son assemblage au substrat source 8. On note également que la couche de carbone particulièrement fine présente une épaisseur très uniforme sur toute la surface du support 9. Une telle épaisseur uniforme et un tel faible niveau de rugosité ne peuvent être obtenus avec des couches plus épaisses, notamment celles excédant plus de 1 ou 10 microns. Le support 9 n'est pas susceptible de se déformer lorsqu'il subit un traitement thermique, par l'effet des contraintes pouvant se développer dans les couches épaisses lorsqu'elles présentent des coefficients de dilatation thermique différents.

La couche de carbone 2 étant de nature différente de celle du substrat source 8, elle peut présenter une surface qui nécessite une préparation elle aussi différente de celle du substrat source 8. Aussi, pour simplifier le procédé de fabrication, et selon une variante de ce procédé, l'invention peut prévoir de former, sur la couche de carbone 2, une couche de collage 7 dont la surface peut être préparée d'une manière similaire à celle du substrat source. Il peut s'agir par exemple d'un nettoyage employant des substances chimiques de compositions identiques ou similaires, dispensées par un même équipement. Cette approche contribue à rendre la fabrication du substrat 1 peu onéreuse.

Lorsque, conformément à cette variante du procédé de fabrication, on souhaite former une couche de collage 7 sur la couche de carbone 2, un second gaz précurseur peut être introduit dans la chambre en remplacement ou en complément du précurseur riche en carbone pour une durée déterminée en vue de déposer une épaisseur de matériau de collage. On veillera à déposer une faible épaisseur afin de limiter autant que possible le temps et le coût de fabrication du substrat 1. Elle peut par exemple être comprise entre quelques dizaines de nanomètres et quelques centaines de nanomètres. Le second gaz précurseur pourra être constitué de SiH4 pour former une couche de collage en silicium, polycristallin ou amorphe.

Ce mode de réalisation « in-situ » est particulièrement avantageux, car il permet de combiner, en une seule étape et sur un seul équipement, l'étape de formation de la couche de carbone 2 et le dépôt du matériau de collage constituant la couche de collage 7. Mais alternativement, le dépôt du matériau de collage peut être réalisé sur un autre équipement, par exemple un équipement permettant de déposer un matériau d'oxyde de silicium. Quels que soient la nature du matériau de collage et l'équipement avec lequel ce matériau est déposé sur la couche de carbone 2, on prendra soin de limiter l'épaisseur à quelques centaines de nanomètres comme cela a été précisé précédemment. L'épaisseur de matériau de collage est ensuite préparée, par exemple par polissage mécanochimique, de manière à rendre sa surface suffisamment lisse, inférieure à 5A RMS, pour permettre son assemblage au substrat source 8. Cela est représenté sur la figure 3c. Cette étape de lissage conduit à amincir l'épaisseur de matériau de collage pour fournir la couche de collage 7 dont l'épaisseur ne doit pas excéder, préférablement, 10nm afin de ne pas trop affecter les performances RF du substrat. A l'issu de cette étape, et comme cela est représenté sur la figure 3d, on dispose d'un support 9 comprenant la couche de collage 7 dont l'épaisseur n'excède pas 10nm, disposée directement sur la couche de carbone 2, elle-même disposée directement sur le substrat de base 3.

Que l'on ait choisi de disposer d'un support 9 comprenant une couche de collage ou pas, le transfert de la couche de dispositifs 5 est réalisé en assemblant la face d'un substrat source 8 au support 9. Le substrat source peut comporter des dispositifs RF ou il peut être formé d'un bloc de matériau dépourvu de dispositif.

Avantageusement, cet assemblage correspond à un collage par adhésion moléculaire des surfaces du substrat 8 et du support 9 mises en contact l'une avec l'autre.

Le transfert peut prévoir, préalablement à l'étape d'assemblage, une étape de formation d'une épaisseur d'isolant électrique sur le support 9 et/ou sur le substrat source 8. Après assemblage, cette épaisseur ou ces épaisseurs forment la couche d'isolant électrique 4. Lorsque l'isolant électrique est formé par dépôt, on peut prévoir de faire suivre ce dépôt par une étape de polissage. Cet isolant électrique peut comprendre, par exemple, de l'oxyde de silicium ou du nitrure de silicium. Lorsque le substrat source est en silicium et dépourvu de dispositif, l'étape de formation de la couche d'isolant peut comprendre son oxydation. Sur la figure 3e, on a représenté le substrat source 8 muni de la couche d'isolant électrique. L'assemblage du substrat source 8 avec le support 9 conduit à placer la couche d'isolant électrique 4 entre le support 9 et le substrat source 8, comme cela est représenté sur la figure 3f lorsque le support 9 ne comprend pas de couche de collage, et sur la figure 3g lorsque le support 9 comprend une couche de collage 7.

Pour renforcer cet assemblage, on peut prévoir d'exposer la structure des figures 3f et 3g à un recuit thermique. Cette étape de recuit peut être positionnée, dans le procédé, directement après l'étape d'assemblage et/ou après l'étape d'amincissement dont la description va suivre. Comme on l'a vu précédemment, ce recuit peut comprendre l'exposition des structures à une température élevée, sans prendre le risque de dégrader les performances RF du substrat obtenu à l'issue du procédé de fabrication.

Après l'étape d'assemblage, le substrat donneur est aminci pour former la couche de dispositifs 5.

Cette étape d'amincissement peut être réalisée par la réduction progressive d'une partie de l'épaisseur du substrat source par amincissement physique et/ou chimique.

Alternativement, il peut s'agir d'une fracture au niveau d'un plan fragile préalablement formé dans le substrat source avant son assemblage au support, selon les principes de la technologie Smart Cut^{™}.

Des étapes de finition de la couche de dispositifs 5, telles qu'une étape de polissage, une étape de traitement thermique sous atmosphère réductrice ou neutre (dans un four vertical, horizontal, ou dans un équipement de traitement thermique rapide), une oxydation sacrificielle peuvent être enchaînées à l'étape d'amincissement.

On dispose à l'issue de ces traitements d'amincissement et, le cas échéant, de finition d'un substrat 1 conforme à l'invention, comme cela est représenté à la figure 3h lorsque le support 9 ne comprend pas de couche de collage, et sur la figure 3i lorsque le support 9 comprend une couche de collage 7.

Lorsque le substrat source 8 est un simple substrat de semi-conducteur, c'est-à-dire qu'il ne comprend pas de dispositif intégré, on forme ainsi un substrat du type semi-conducteur sur isolant, dans lequel la couche de dispositifs 5 est une couche de semi-conducteurs vierge. Le substrat peut être alors utilisé pour la formation de dispositifs intégrés, et notamment de circuits intégrés radiofréquences.

Lorsque le substrat source 8 a été préalablement traité pour former à sa surface des dispositifs intégrés, on dispose à l'issue de ce procédé d'une couche de dispositifs 5 qui comprend ces dispositifs.

Bien entendu l'invention n'est pas limitée aux modes de mise en œuvre décrits et on peut y apporter des variantes de réalisation sans sortir du cadre de l'invention tel que défini par les revendications.

## Revendications

1. Substrat (1) pour des applications dans les domaines de l'électronique et de la microélectronique radiofréquence comprenant :
- un substrat de base (3) ;
- une unique couche de carbone (2) disposée sur et directement en contact avec le substrat de base (3), la couche de carbone (2) n'étant pas une couche de graphite et présentant une épaisseur strictement comprise entre 1 nm et 5nm ;
- une couche d'isolant électrique (4) disposée sur la couche de carbone (2);
- une couche de dispositifs (5) disposée sur la couche d'isolant (4).

2. Substrat (1) selon la revendication précédente dans lequel le substrat de base (3) est un substrat de silicium monocristallin présentant une résistivité inférieure à 100 ohm.cm.

3. Substrat (1) selon la revendication 1 dans lequel le substrat de base (3) est un substrat de silicium monocristallin présentant une résistivité supérieure à 100 ohm.cm.

4. Substrat (1) selon l'une des revendications précédentes dans lequel la couche de carbone (2) présente une épaisseur comprise entre 1 et 3nm.

5. Substrat (1) selon l'une des revendications précédentes comprenant en outre une couche de collage (7) disposée entre, et en contact avec, la couche de carbone (2) et la couche d'isolant électrique (4).

6. Substrat (1) selon la revendication précédente dans lequel la couche de collage (7) présente une épaisseur inférieure à 10nm.

7. Substrat (1) selon l'une des deux revendications précédentes dans lequel la couche de collage (7) est en silicium amorphe, polycristallin ou en dioxyde de silicium.

8. Substrat (1) selon l'une des revendications précédentes dans lequel la couche d'isolant (4) comprend du dioxyde de silicium.

9. Substrat (1) selon l'une des revendications précédentes dans lequel la couche de dispositifs (5) comprend du silicium.

10. Substrat (1) selon l'une des revendications précédentes dans lequel la couche de dispositifs (5) comprend au moins un dispositif radiofréquence.
